# EUROPÄISCHE PATENTSCHRIFT

(11) **EP 1 392 882 B1**
(45) Veröffentlichungstag und Bekanntmachung des Hinweises auf die Patenterteilung: **08.12.2004**
(21) Anmeldenummer: 02743144.4
(22) Anmeldetag: 04.06.2002
(51) Int. Cl.: C23C 14/32, H01J 37/32

(54) **VERFAHREN ZUM BEHANDELN EINES SUBSTRATS**
METHOD FOR TREATING A SUBSTRATE
PROCEDE DESTINE AU TRAITEMENT D'UN SUBSTRAT

(30) Priorität: 05.06.2001 DE 10126986
(43) Veröffentlichungstag der Anmeldung: 03.03.2004
(73) Patentinhaber: swiss-Plas.com AG, 2540 Grenchen (CH); Gabriel, Herbert M., 64625 Bensheim (DE)
(72) Erfinder: CURTINS, Hermann, CH-2540 Grenchen (CH)
(74) Vertreter: Stoffregen, Hans-Herbert, Dr. Dipl.-Phys.
(86) Internationale Anmeldenummer: PCT/EP2002/006085
(87) Internationale Veröffentlichungsnummer: WO 2002/101113

(56) Entgegenhaltungen:
- EP-A- 0 732 420
- WO-A-99/22396
- US-A- 3 494 852
- PATENT ABSTRACTS OF JAPAN vol. 014, no. 580 (E-1017), 25. Dezember 1990 (1990-12-25) & JP 02 251143 A (SUMITOMO ELECTRIC IND LTD), 8. Oktober 1990 (1990-10-08)

## Beschreibung

Die Erfindung bezieht sich auf ein Verfahren zum Ätzen eines Substrats in einer Lichtbogenverdampfungsvorrichtung , in der in einem evakuierten Raum zwischen einer Anode und einem als Kathode wirkenden aus Metall bestehenden Target ein Lichtbogenstrom der Stärke 1 zum Verdampfen von Targetmaterial und Erzeugen einer Metallionendichte fließt.

Um auf Materialien wie Werkstücken Schichten, insbesondere Hartmetallschichten aufzubringen, ist es erforderlich, dass die zu beschichtenden Oberflächen in atomarem Maßstab frei von Verunreinigungen sind, um ein sicheres Haften des aufzubringenden Materials zu ermöglichen.

Das Auftragen der Schichten kann z. B. durch Sputter in einer Vakuumkammer bei einer Spannung im Bereich zwischen 400 Volt und 1500 Volt und einer Stromstärke zwischen 1 Ampere und 10 Ampere erfolgen. Wendet man die Lichtbogentechnik an, so liegen typischerweise zwischen Anode und Kathode eine Spannung von 20 Volt beim Fließen eines Stroms in der Größenordnung von 100 Ampere an.

Aus der EP 0 306 491 B1 ist eine Lichtbogenverdampfungsvorrichtung bekannt. Um eine Legierungsschicht auf ein Bauteil aufzubringen, wird ein Target benutzt, das zumindest zwei verschiedene Metalle in verschiedenen aktiven Flächenabschnitten des Targets aufweist.

Damit zum Verdampfen von Metall und damit zum Erzeugen eines Plasmas ein Lichtbogenspot auf einer Randombahn über die gesamte Fläche eines Targets bewegt wird, sieht die DE 42 43 592 A1 eine Stromzuführung zum Target über eine Magnetspule vor, die ihrerseits das zum Bewegen des Lichtbogenspots erforderliche Magnetfeld erzeugt.

Bei der Vorbehandlung des zu beschichtenden Substrats wie Werkzeugs, also beim Ätzen, ist auf Grund der hohen Metallionendichte pro Kathode, die bei einem stabilen Lichtbogenstrom entsteht, festzustellen, dass unerwünschte Effekte auftreten wie zu hohe Erwärmung des Substrats (Werkzeug) und damit verbundener Verlust der Härte des Gnindmaterials des Substrats sowie Veränderung der Geometrie des Substrats oder Auftragen von verdampftem Material durch vom Targetmaterial emittierte Atome und Atomverbände (Droplets), wodurch eine schlechte Haftung sodann aufzutragender Schicht sowie eine Aufrauung des Substrats gegeben ist.

Die EP 0 732 420 A2 bezieht sich auf eine Lichtbogen-Verdampfungsvorrichtung mit einer einen Tiegel aufweisenden Anode, dem ein zu verdampfender Draht zugeführt wird, sowie einer Kathode, die mit der Anode in einem Vakuumunterteil angeordnet ist. Die verdampften Materialien gelangen auf eine zu beschichtende Trägerplatte, wobei der Metalldampf über Abdeckblenden einstellbar ist. Die Trägerplatte ist mit einer Folie teilweise abgedeckt.

Der vorliegenden Erfindung liegt das Problem zu Grunde, ein Verfahren der eingangs genannten Art so weiterzubilden, dass ein Behandeln wie Ätzen des Substrates im eriorderlichcn Umfang erfolgt, ohne dass eine unzulässige Aufheizung auftritt. Des Weiteren soll die Möglichkeit geschaffen werden, dass durch die Behandlung des Substrats störende Moleküle (Restgasatome) überaus schnell entfernt werden können. Schließlich soll dann, wenn in der Lichtbogenverdampfungsvorrichtung mehrere Targets vorhanden sind, sichergestellt werden, dass parasitäre Abscheidungen auf nicht benutzten Targets ausgeschlossen werden.

Das Problem wird durch ein Verfahren der eingangs genannten Art im Wesentlichen dadurch gelöst, dass die für das Behandeln des Substrats wirksame Metallionendichte pro Target durch zumindest teilweises Abdecken des Targets eingestellt wird, wobei eine Veränderung der Metallionendichte pro Target derart erfolgt, dass eine scheinbare Lichtbogenstromstärkenreduzierung auf einen Wert erfolgt, bei dem zwischen der Anode und der Kathode ein instabiler Lichtbogenstrom fließt.

Erfindungsgemäß wird die für das zu behandelnde Substrat wirksame Metallionendichte pro Target derart beeinflußt, dass diese bei unverändert stabilem Lichtbogen zwischen Anode und Target in einem Umfang reduziert wird, dass eine unzulässige Erwärmung des Substrats unterbleibt. Es erfolgt eine scheinbare Reduzierung der Stromstärke des Lichtbogens zu Werten hin, bei denen eine lineare Lichtbogenquelle bei einem Unterdruck im Bereich z. B. ≤ 0,0001 Millibar an und für sich keine stabilen Betriebsbedingungen mehr aufweist, also bei Strömen unter in etwa 60 Ampere (für typische Rechteckverdampfer).

Die geringen Stromstärken entsprechenden Metallionendichten pro Target werden nunmehr für das Substrat wirksam, so dass das gewünschte Behandeln wie Ätzen ohne das Risiko erfolgt, dass durch Überhitzung eine Substratveränderung wie -verformung erfolgt. Dabei kann die Metallionendichte pro Target dadurch variiert werden, dass das Target substratseitig über zumindest eine Abdeckung in Form z. B. einer verschwenkbaren Klappe im gewünschten Umfang abgedeckt wird. Insbesondere wird das Target substratseitig über zwei verschwenkbare Klappen abgedeckt.

Alternativ kann das Target substratseitig über gegeneinander verstellbare wie verschiebbare Öffnungen aufweisende Elemente abgedeckt sein, wobei durch Verstellen der Elemente die Öffnungen im gewünschten Umfang zueinander fluchtend oder versetzt zueinander ausgerichtet werden. Auch durch diese Möglichkeit ist die Metallionendichte pro Target, die für das Substrat wirksam wird, einstellbar.

In Weiterbildung der Erfindung ist vorgesehen, dass das zwischen dem Target und der Abdeckung sich ausbildende Plasma zum Binden von Gasmolekülen auf targetseitiger Fläche der Abdeckung benutzt wird, also als Getterpumpe dient, wodurch eine Getterpumpe mit hoher Pumpleistung zur Verfügung gestellt wird. So haben Messungen ergeben, dass sich eine Pumpleistung von 10.000 Liter pro Sekunde bei 100 Ampere pro Target und insgesamt 4 aktiven Targets ergibt, die ihrerseits aus Titan oder Chrom oder einem anderen Targetmaterial mit Getierwirkung bestehen können.

Diese bei abgedeckten Targets gebildeten Getterpumpen weisen Pumpleistungen auf, die erheblich größer als die eigentliche Pumpenleistung der in der Lichtbogenverdampfungsvorrichtung integrierten Turbopumpe ist, deren Leistung üblicherweise bei 500 bis 1000 Liter pro Sekunde liegt. Dabei wird die Pumpleistung der erfindungsgemäß, ausgebildeten Getterpumpen insbesondere dann besonders wirksam, wenn das Substrat geätzt wird. Somit wird ausgeschlossen, dass sich Gasmoleküle in der Oberfläche des zu behandelnden Substrats einlagern können, wodurch der gewünschte Hafungseffekt der Oberfläche negativ beeinflußt werden würde.

Durch die Wirkung des zwischen dem bzw. den Targets und den diese substratseitig verschließenden Abdeckungen sich ausbildenden Plasmas ergibt sich des Weiteren der Vorteil, dass der eigentliche Behandlungs- wie Ätzprozess früher gestartet werden kann als bei üblichen Lichtbogenverdampfungsvorrichtungen, die allein mit konventionellen gesonderten Pumpen arbeiten. Vergleichsmessungen haben gezeigt, dass sich mit der erfindungsgemäßen Lehre eine Zeitverkürzung ohne Weiteres um ein Drittel ergibt. Normalerweise erfolgt die Aufheizung der Substrate schneller als die Ausgasungen im Kammerinneren.

Ein weiterer Vorteil der erfindungsgemäßen Lehre ist darin zu sehen, dass nicht genutzte Targets gegenüber parasitärer Abscheidungen beim Aulheizen der zu behandelnden Substrate oder während des Abscheidens mit nur einer Kathode dadurch geschützt werden, dass diese vollständig abgedeckt werden. Somit sind keine zusätzlichen Reinigungsprozesse für gegebenenfalls verschmutzte Targets erforderlich.

Aber auch beim Beschichten des Substrats ergeben sich Vorteile, da beim Beschichten des Substrats z.B. mit Titannitrid bei Verwendung eines Targets aus Titan und Zuführen von Stickstoff ein Schichtauftrag durch die Targetabdeckungen derart kontrolliert durchgeführt werden, dass überaus präzise dünne Schichten sogar im Nano-Lagenbereich aufbaubar sind. Auch besteht die Möglichkeit, Mehrlagenschichten auszubilden, die gegebenenfalls aus unterschiedlichen Materialien bestehen, sofern die zum Einsatz gelangenden Targets selbst aus unterschiedlichen Materialien bestehen.

Ferner wird das Ätzen mit einem Inertgas wie Argon bei Drücken im 10⁻³ mbar - Bereich möglich. Das ansonsten nicht mögliche Inertgas-Ätzen wirkt sehr gleichmäßig und schonend - aufgrund sehr kleiner lonenströme - auf die Substrate. Nach dem Stand der Technik müssten sehr teure Ionisationshilfen eingebaut werden. Mit anderen Worten ist ein Inertgasionenätzen bei gleichzeitigem Getterpumpeneffekt möglich.

Weitere Einzelheiten. Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung von der Zeichnung zu entnehmenden bevorzugten Ausführungsbeispielen.

Es zeigen:
- Fig.1: eine Prinzipdarstellung einer Vakuumkammer einer Lichtbogenverdampfungsvorrichtung.
- Fig. 2: eine Pirinzipdarstellung der Erstreckung eines auf ein Substrat einwirkenden Plasmas durch einem Target zugeordnete Abdeckung und
- Fig.3: eine Grafik betreffend der in einer Lichibogenverdampfungsvorrichtung erzeugten Metallionendichtung in Abhängigkeit vom Lichtbogenstrom.

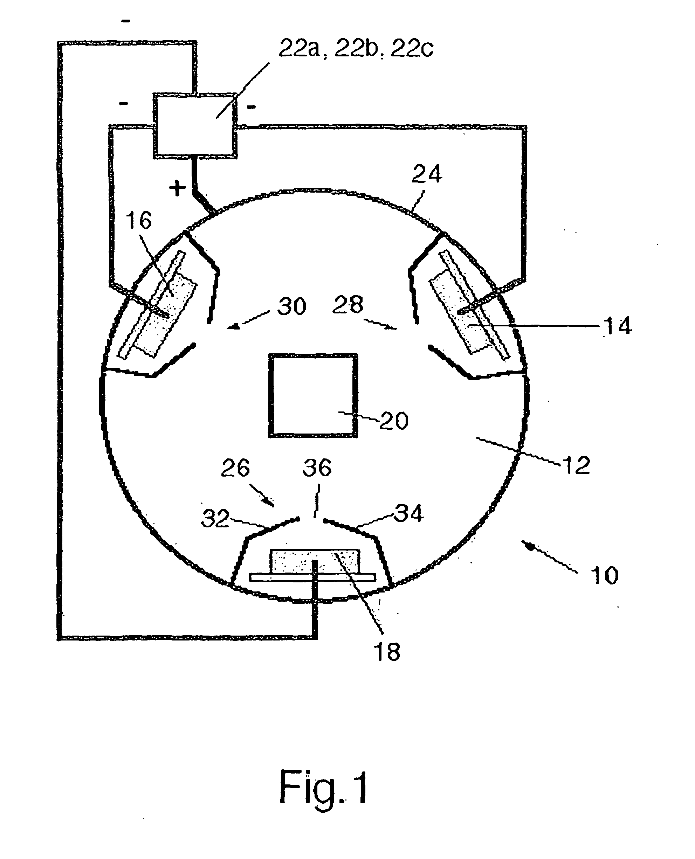

In Fig. 1 ist rein prinzipiell eine Lichtbogenverdampfungsvorrichtung 10 dargestellt, die eine Vakuumkammer 12 mit in dieser angeordneten die Funktion von Kathoden ausübenden Targets 14, 16, 18 aufweist. Im Inneren der Vakuumkammer 12 befinden sich z. B. auf einem Drehteller angeordnete Substrate 20, die nach der erfindungsgemäßen Lehre zumindest geätzt, insbesondere jedoch zunächst geätzt und sodann beschichtet werden sollen. Ein hierzu erforderliches Plasma wird durch Verdampfen des Targetmaterials durch Ausbilden eines Lichtbogenstroms zwischen der Kathode bzw. dem Target 14 und/oder 16 und/oder 18 einerseits und der Anode andererseits erzeugt, die mit der Verdampfungskammer 12 bzw. deren Wandung 24 verbunden ist. Insoweit wird jedoch auf hinlängliche Konstruktionen und Techniken verwiesen, genauso wie im Bezug auf die anzulegende Spannung, die in der Größenordnung von 20 Volt liegen kann, bzw. den fließenden Strom in der Größenordnung von 100 Ampere. Der Druck in der Lichibogenkammcr 12 wird in Abhängigkeit des auszubildenden Plasmas bzw. Ätz- bzw. Beschichtungsprozess ausgelegt und beläuft sich im Bereich zwischen 10⁻⁴ bis 10³ Pa, um nur beispielhaft Werte zu nennen.

Über den einzelnen Targets 14, 16, 18 zugeordneten Spannungsquellen 22a,22b, 22c werden erstere einzeln oder in gewünschter Kombination mit Spannung beaufschlagt.

Erfindungsgemäß ist nun vorgesehen, dass die Targets 14, 16, 18 gegenüber dem Substrat, 20 im gewünschten Umfang abdeckbar sind, wodurch die Metallionendichte pro Target 14, 16, 18 veränderbar ist, und zwar in einem Umfang, dass ungeachtet eines stabilen Lichtbogenstroms und damit Ausbilden eines Lichtbogenspots auf der Oberfläche des verdampfenden Targets 14, 16, 18 eine unerwünschte Überhitzung der Substrate 18 beim Ätzen nicht erfolgt.

Somit ist sichergestellt, dass die Oberfläche der Substrate 20 im erforderlichen Umfang gereinigt werden, um sodann Metallschichten wie Hartmetallschichten bei guter Haftung aufzutragen.

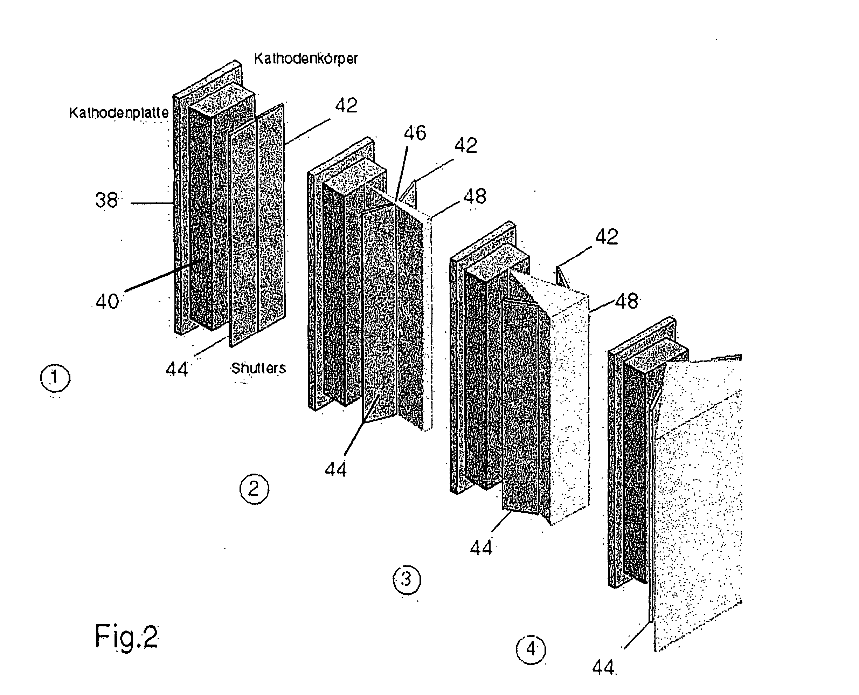

Im Ausführungsbeispiel handelt es sich bei den Abdeckungen 26, 28, 30 um zweiflügelige Klappen 32, 34, die in Abhängigkeit von deren Stellung zueinander das jeweilige Target 14, 16, 18 vollständig abdecken oder einen Schlitz 36 gewünschter Breite freigeben, durch den sich ein Plasma in Richtung der Substrate 20 ausbilden kann. Dies wird anhand der Fig. 2 verdeutlicht. So ist rein prinzipiell ein Träger 38 für ein Target 40 dargestellt, das oberflächenseitig mittels auch als Shutter zu bezeichnender Klappen 42, 44 in Richtung eines nicht dargestellten Substrats abdeckbar ist.

In der Darstellung 1 in Fig. 2 sind die Klappen 42, 44 vollständig geschlossen, so dass sich ein Plasma z.B. aus Titanionen nicht in Richtung des Substrats ausbilden kann.

In der Position 2 weisen die Klappen 42, 44 einen Öffnungsschlitz 46 zueinander auf, der es ermöglicht, dass ein Plasma 48 in Richtung des Substrats austritt. Die Erstreckung des Plasmas und damit die Metallionendichte verändert sich dabei in Abhängigkeit von der Spaltbreite zwischen den Klappen 42, 44, wie die weiteren Darstellungen 3 und 4 in Fig. 2 verdeutlichen. Somit kann durch die Stellung der Klappen 42, 44 die aus dem Target 14 frei werdende Metallionendichte im gewünschten Umfang variiert werden mit der Folge, dass die auf das Substrat auftreffende Metallionendichte derart verändert werden kann, dass beim Reinigungsprozess, also beim Ätzen eine unerwünschte Überhitzung unterbleibt.

Aber auch beim Beschichten mit Metallschichten wie Titannitrid bieten die Klappen 42, 44 den Vorteil, dass gezielt dünne Schichten bzw. mehrere Schichtlagen auf die Substrate 20 auftragbar sind, wobei die Schichten selbst aus unterschiedlichen Materialien bestehen können, nämlich dann, wenn sich in der Vakuumkammer 12 Targets unterschiedlicher Materialien befinden, die entsprechend der gewünschten Schichtfolge ein für das Substrat wirksames Plasma erzeugen.

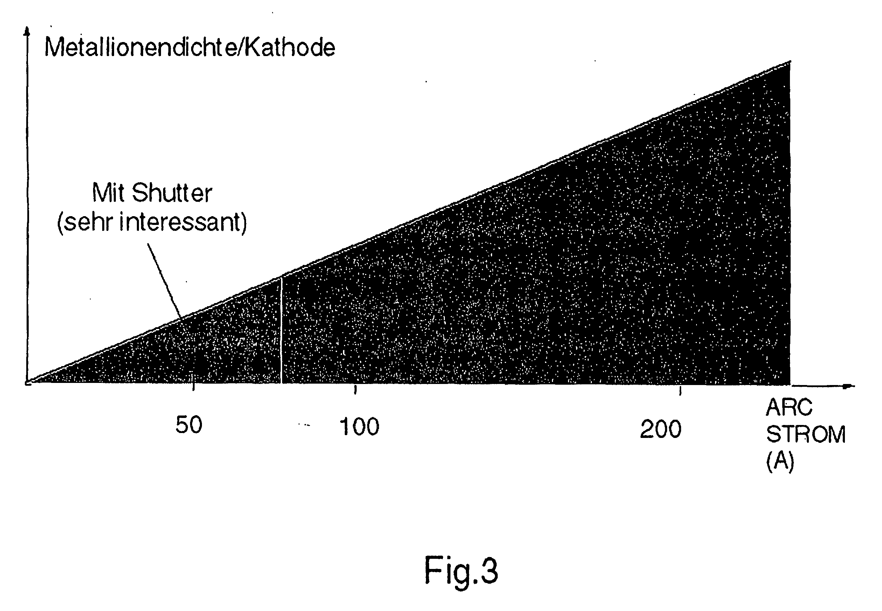

Die Wirkung der Abdeckungen 26, 28, 30, also der Klappen 32, 34 bzw. 42, 44 ist derart, dass eine scheinbare Verringerung des Lichtbogenstroms derart erfolgt, dass eine gewünschte Reduzierung der Metallionendichte pro Target bzw. Kathode erfolgt. Die für das Substrat 20 wirksame Metallionendichte pro Kathode kann mittels der Abdeckung 26, 28, 30 derart reduziert werden, als wenn der Lichtbogenstrom auf Werte heruntergefahren wäre, bei der an und für sich ein stabiler Lichtbogen nicht mehr erzielbar ist, also im Bereich von 60 Ampere oder weniger bei einem Druck in der Vakuumkammer 12 von 0,0001 mbar oder weniger. Dieser Bereich ist in der Fig. 3 mit dem Bezugszeichen 50 gekennzeichnet. Mit anderen Worten erfolgt eine scheinbare Lichtbogenstromreduzierung, die jedoch nicht zu einer Instabilität des Lichtbogens selbst führt. Somit ergeben sich auch Vorteile bei Niedertemperaturbeschichtung.

Die Möglichkeit, die Kathode bzw. Targets 14, 16, 18 vollständig abzudecken, bietet noch einen weiteren Vorteil. So kann bei einem sich auf einem Target 14, 16, 18 ausbildenden Lichtbogen die Funktion einer Getterpumpe dann erreicht werden, wenn das entsprechende Target vollständig abgedeckt ist. In diesem Fall werden in der Vakuumkammer vorhandene Gasmoleküle auf Grund des sich zwischen dem Target und der Abdeckung ausgebildeten Plasmas durch die sich auf der Abdeckung abscheidenden Targetpartikel gebunden, so dass in Folge dessen Gasmoleküle nicht in der Oberfläche des Substrats 20 nicht oder nur im vemachlässigendem Umfang eingelagert werden. Dabei zeigt eine entsprechend generierte Getterpumpe eine Pumpleistung von z.B. 10.000 Liter pro Sekunde bei einer Stromstärke von 100 Ampere pro Kathode und eingesetzten insgesamt 4 aktiven Kathoden. Hierdurch bedingt kann der eigentliche Ätzprozess früher als bei bekannten Verfahren eingesetzt werden.

Des Weiteren ergibt sich der Vorteil, dass nicht genutzte Targets vollständig abgedeckt werden können, so dass ein parasitäres Abscheiden von Fremdstoffen ausgeschlossen ist.

Die erfindungsgemäße Lehre bietet daher insbesondere folgende Vorteile:
bessere Oberflächenreinigung,
bessere Haftung von aufzubringenden Metallschichten,
Prozessverkürzung,
Vermeidung von Verunreinigungen von ungenutzten Targets,
Ausbildung von Schichtfolgen,
Ausbilden von extrem dünnen Schichten (Nanolagenschichten),
effiziente Inertgasionenätzung bei niedrigen Inertgasdrücken,

Durchführung besserer Niedertemperaturbeschichtung durch Reduktion der lonendichte bei kontinuierlichem Plasma.

## Patentansprüche

1. Verfahren zum Ätzen eines Substrates (20) in einer Lichtbogenverdampfungsvotrichtung (10), in der in einem evakuierten Raum (12) zwischen einer Anode und einem als Kathode wirkenden aus Metall bestehenden Target (14, 16, 18, 40) ein Lichtbogenstrom der Stärke I zum Verdampfen von Targetmaterial und Erzeugen einer Metallionendichte fließt,
**dadurch gekennzeichnet,**
**dass** die für das Behandeln des Substrats (20) wirksame Metallionendichte pro Target (14, 16, 18, 40) durch zumindest teilweises Abdecken des Targets eingestellt wird, wobei eine Veränderung der Metallionendichte pro Target (14, 16, 18, 40) derart erfolgt, dass eine scheinbare Lichtbogenstromstärkenreduzierung auf einen Wert erfolgt, bei dem zwischen der Anode und der Kathode ein instabiler Lichtbogenstrom fließt.

2. Verfahren nach Anspruch 1,
**dadurch gekennzeichnet,**
**dass** die Metallionendichte pro Target (14, 16, 18, 40) in einem Umfang reduziert wird, dass eine unzulässige Erwärmung des Substrats (20) unterbleibt.

3. Verfahren nach Anspruch 1,
**dadurch gekennzeichnet,**
**dass** das Target (14, 16, 18, 40) substratseitig über zumindest eine Abdeckung (26, 28, 30) vorzugsweise in Form einer verschwenkbaren Klappe (32, 34, 42, 44) im gewünschten Umfang abgedeckt wird.

4. Verfahren nach Anspruch 3,
**dadurch gekennzeichnet,**
**dass** das Target (14, 16, 18, 40) substratseitig über zwei verschwenkbare Klappen (32, 34, 42,44) im gewünschten Umfang abgedeckt wird.

5. Verfahren nach Anspruch 1,
**dadurch gekennzeichnet,**
**dass** das Target (14, 16, 18, 40) substratseitig über gegeneinander verstellbare wie verschiebbare Öffnungen aufweisende Elemente abgedeckt wird, wobei durch Verstellen der Elemente die Öffnungen im gewünschten Umfang zueinander fluchtend oder versetzt zueinander ausgerichtet werden.

6. Verwendung einer Vorrichtung zum Ätzen eines Substrats (20) in einer Lichtbogenverdampfungsvorrichtung (10) umfassend eine von Wandungen (24) umgebene Vakuumkammer (12), eine Anode und eine Kathode sowie zumindest ein Target (14, 16, 18, 40), aus dem zum Ätzen des Substrats Metallionen durch Bewegen eines Lichtbogenspots auf dem Target austreten, wobei die Wandung (24) der Vakuumkammer (12) mit der Anode verbunden ist und das Target oder mehrere Targets (14,16, 18, 40) die Kathode sind, zwischen dem Substrat (20) und dem Target bzw. den Targets ein das Substrat im gewünschten Umfang abdeckende Abdeckung (26, 28, 30, 32, 34, 42, 44) angeordnet ist und das Substrat gegenüber dem Target bzw. den Targets auf negativem Potential liegt, bei abgedecktern und mit einem Lichtbogen beaufschlagten Target (14, 16, 18, 40) zum Gettem von Gasmolekülen.

7. Verwendung einer Vorrichtung zum Ätzen eines Substrats (20) in einer Lichtbogenverdampfungsvorrichtung (10) umfassend eine von Wandungen (24) umgebene Vakuumkammer (12), eine Anode und eine Kathode sowie zumindest ein Target (14, 16, 18, 40), aus dem zum Ätzen des Substrats Metallionen durch Bewegen eines Lichtbogenspots auf dem Target austreten, wobei die Wandung (24) der Vakuumkammer (12) mit der Anode verbunden ist und das Target oder mehrere Targets (14, 16, 18, 40) die Kathode sind, zwischen dem Substrat (20) und dem Target bzw. den Targets ein das Substrat im gewünschten Umfang abdeckende Abdeckung (26, 28, 30, 32, 34, 42, 44) angeordnet ist und das Substrat gegenüber dem Target bzw. den Targets auf negativem Potential liegt, zum Inertgasionenätzen.

## Claims

1. A method for etching a substrate (20) in an arc evaporation device (10) in which an arc current of an intensity I flows in an evacuated space (12) between an anode and a target (14, 16, 18, 40) comprising metal and acting as a cathode in order to evaporate target material and generate a metal ion density,
**characterized in**
**that** the metal ion density per target (14, 16, 18, 40) effective for treatment of the substrate (20) is regulated by at least partially covering the target, where the metal ion density per target (14, 16, 18, 40) is changed such that an apparent arc current intensity reduction is achieved to a value at which an unstable arc current flows between the anode and the cathode.

2. Method according to Claim 1,
**characterized in**
**that** the metal ion density per target (14, 16, 18, 40) is reduced to an extent that no inadmissible heating up of the substrate (20) occurs.

3. Method according to Claim 1,
**characterized in**
**that** the target (14, 16, 18, 40) is covered to the required extent on the substrate side by at least one cover (26, 28, 30) preferably in the form of a swivellable flap (32, 34, 42, 44).

4. Method according to Claim 3,
**characterized in**
**that** the target (14, 16, 18, 40) is covered to the required extent on the substrate side by two swivellable flaps (32, 34, 42, 44).

5. Method according to Claim 1,
**characterized in**
**that** the target (14, 16, 18, 40) is covered on the substrate side using elements having openings adjustable and movable relative to each other, where the openings can be aligned to the desired extent flush or offset to one another by adjustment of the elements.

6. Use of a device for etching a substrate (20) in an arc evaporation device (10) comprising a vacuum chamber (12) surrounded by walls (24), an anode and a cathode and at least one target (14, 16, 18, 40), from which for etching of the substrate metal ions are emitted by movement of an arc spot on the target, where the wall (24) of the vacuum chamber (12) is connected to the anode and the target or several targets (14, 16, 18, 40) are the cathode, a cover (26, 28, 30, 32, 34, 42, 44) covering the substrate to the desired extent is arranged between the substrate (20) and the target(s) and the substrate opposite the target(s) is connected to negative potential, with the target (14, 16, 18, 40) covered and subjected to an arc for gettering gas molecules.

7. Use of a device for etching a substrate (20) in an arc evaporation device (10) comprising a vacuum chamber (12) surrounded by walls (24), an anode and a cathode and at least one target (14, 16, 18, 40), from which for etching of the substrate metal ions are emitted by movement of an arc spot on the target, where the wall (24) of the vacuum chamber (12) is connected to the anode and the target or several targets (14, 16, 18, 40) are the cathode, a cover (26, 28, 30, 32, 34, 42, 44) covering the substrate to the desired extent is arranged between the substrate (20) and the target(s) and the substrate opposite the target(s) is connected to negative potential for inert gas ion etching.

## Revendications

1. Procédé de traitement d'un substrat (20) dans un dispositif de vaporisation à arc électrique (10), dans lequel un courant d'arc électrique d'intensité I circule dans un espace vidé d'air (12) entre une anode et une cible (14, 16, 18, 40) faite de métal jouant le rôle de cathode, pour vaporiser de la matière de la cible et pour produire une densité d'ions de métal,
**caractérisé en ce que**
la densité d'ions de métal par cible (14, 16, 18, 40) efficace pour le traitement du substrat (20) est réglée par masquage au moins partiel de la cible, une modification de la densité d'ions de métal par cible (14, 16, 18, 40) étant effectuée de manière à produire une réduction apparente de l'intensité du courant d'arc électrique jusqu'à une valeur à laquelle un courant d'arc électrique instable circule entre l'anode et la cathode.

2. Procédé selon la revendication 1,
**caractérisé en ce que**
la densité d'ions de métal par cible (14, 16, 18, 40) est réduite à un degré tel qu'il se ne se produit pas d'échauffement inadmissible du substrat (20).

3. Procédé selon la revendication 1,
**caractérisé en ce que**
côté substrat, la cible (14, 16, 18, 40) est masquée, dans la mesure souhaitée, au moyen d'au moins un masque (26, 28, 30) formé de préférence d'un volet pivotant (32, 34, 42, 44).

4. Procédé selon la revendication 3,
**caractérisé en ce que**
côté substrat, la cible (14, 16, 18, 40) est masquée dans la mesure souhaitée au moyen de deux volets pivotants (32, 34, 42, 44).

5. Procédé selon la revendication 1,
**caractérisé en ce que**
côté substrat, la cible (14, 16, 18, 40) est masquée au moyen d'éléments présentant des ouvertures et qu'on peut déplacer, par exemple en translation, les uns par rapport aux autres, les ouvertures étant ajustées les unes par rapport aux autres en alignement entre elles ou dans des positions décalées dans la mesure souhaitée par le déplacement des éléments.

6. Utilisation d'un dispositif destiné à traiter un substrat (20) dans un dispositif de vaporisation à l'arc électrique (10), comprenant une chambre à vide (12) entourée de parois (24), une anode et une cathode ainsi qu'au moins une cible (14, 16, 18, 40) d'où des ions de métal sortent sous l'effet du déplacement d'un spot d'arc électrique pour traiter le substrat, la paroi (24) de la chambre à vide (12) étant connectée à l'anode et la cible ou plusieurs cibles (14, 16, 18, 40) étant la cathode, un masque (26, 28, 30, 32, 34, 42, 44) qui masque le substrat dans la mesure souhaitée étant disposé entre le substrat (20) et la cible ou les cibles, et le substrat se trouvant à un potentiel négatif par rapport à la cible ou aux cibles, lorsque la cible (14, 16, 18) est masquée et attaquée par un arc électrique pour absorber des molécules gazeuses.

7. Utilisation d'un dispositif destiné à traiter un substrat (20) dans un dispositif de vaporisation à l'arc électrique (10), comprenant une chambre à vide (12) entourée de parois (24), une anode et une cathode ainsi qu'au moins une cible (14, 16, 18, 40) d'où des ions de métal sortent sous l'effet du déplacement d'un spot d'arc électrique pour traiter le substrat, la paroi (24) de la chambre à vide (12) étant connectée à l'anode et la cible ou plusieurs cibles (14, 16, 18, 40) étant la cathode, un masque (26, 28, 30, 32, 34, 42, 44) qui masque le substrat dans la mesure souhaitée étant disposé entre le substrat (20) et la cible ou les cibles, et le substrat se trouvant à un potentiel négatif par rapport à la cible ou aux cibles, pour effectuer l'attaque par ions de gaz inertes.
